# EUROPEAN PATENT SPECIFICATION

(11) **EP 0 461 778 B1**
(45) Date of publication and mention of the grant of the patent: **03.01.1996**
(21) Application number: 91304793.2
(22) Date of filing: 28.05.1991
(51) Int. Cl.: G03F 1/14

(54) **Method for producing a mask pattern**
Verfahren zur Herstellung eines Maskenmusters
Méthode de fabrication d'un masque

(30) Priority: 15.06.1990 JP 158420/90
(43) Date of publication of application: 18.12.1991
(73) Proprietor: MITSUBISHI DENKI KABUSHIKI KAISHA, Tokyo (JP)
(72) Inventor: Minami, Hiroyuki, c/o Mitsubishi Denki K.K., 1 Mizuhara 4-chome, Itami-shi, Hyogo-ken (JP)
(74) Representative: Beresford, Keith Denis Lewis

(56) References cited:
- EP-A- 437 376
- EP-A- 0 234 547
- PATENT ABSTRACTS OF JAPAN vol. 11, no. 261 (P-609)(2708) 25 August 1987 & JP-A-62 67514

## Description

### FIELD OF THE INVENTION

The present invention relates to a method of producing a mask pattern used in an optical exposure apparatus using a single wavelength.

### BACKGROUND OF THE INVENTION

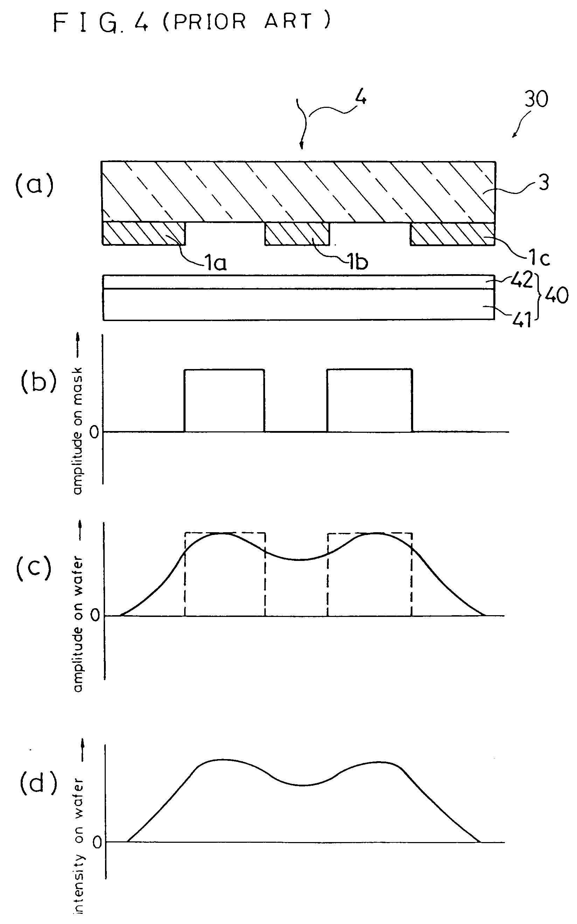

Figures 4(a) to 4(d) show a principle of patterning a mask pattern, which is generally used, in which figure 4(a) shows cross-sectional structures of a mask pattern and exposed wafer, figure 4(b) shows an amplitude distribution of the incident light on the mask pattern, figure 4(c) shows an amplitude distribution of light on a wafer which is to be exposed with the light transmitted through the mask pattern, and figure 4(d) shows an intensity distribution of the light on the exposed wafer.

In these figures, reference numeral 30 designates a mask pattern comprising light shielding films 1a, 1b, and 1c and a glass substrate 3. The light shielding films 1a, 1b, and 1c comprise metal such as Cr and provided on a first surface of the glass substrate 3. Reference numeral 4 designates a monochromatic light having a single wavelength incident on a second surface of the glass substrate 3. Reference numeral 40 designates a wafer which is to be exposed with the light 4 transmitted through the mask pattern 30, and it comprises a substrate 41 and a resist layer 42 disposed on the substrate 41.

In figure 4(a), when exposure light 4 having a single wavelength is incident on the mask pattern from above, an amplitude distribution of the incident light on the mask pattern 30 has the same phases as shown in figure 4(b). The amplitude of the incident light which has transmitted through the mask pattern 30 is distributed on the wafer 40 as shown in figure 4(c). In figure 4(c), the dotted line represents the amplitude distribution of the light on the mask pattern 30 and the full line represents the amplitude distribution of light on the wafer 40. When the light amplitudes on the mask pattern 30 have the same phases and the light shielding film 1b provided at the aperture between the shielding films la and 1c is a fine pattern, diffracted light enters the pattern 1b, thereby resulting in the amplitude distribution as shown by the full line. Hence, the intensity distribution of the incident light on the wafer 40 is as shown in figure 4(d) and fine resist patterns cannot be produced on the substrate 41.

A prior art phase-shifting method that is developed in order to solve the above-described problems will be explained.

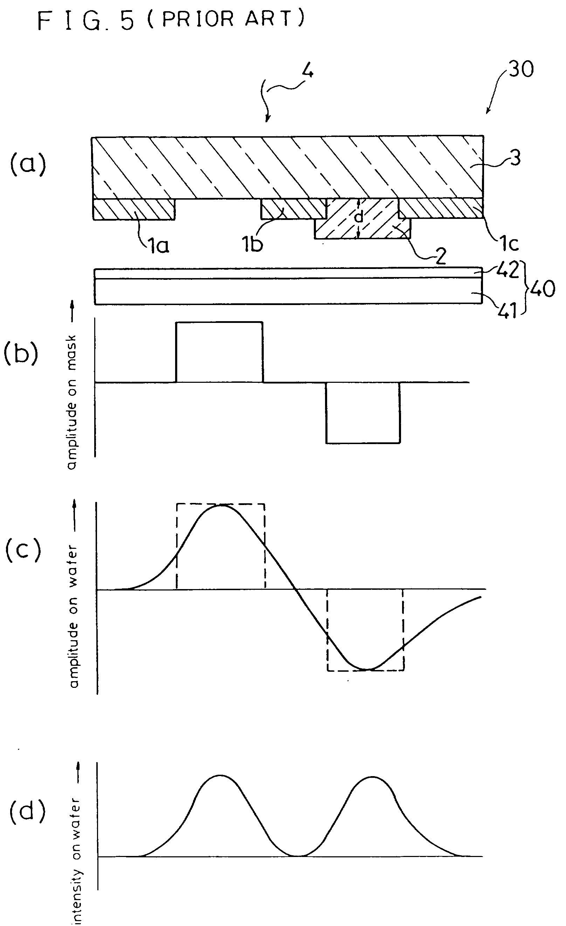

Figures 5(a) to 5(d) show a principle of patterning by using the phase-shifting method, in which figure 5(a) shows a cross-sectional view of a mask pattern in the phase-shifting method, figure 5(b) shows an amplitude distribution of the incident light on the mask pattern, figure 5(c) shows an amplitude distribution of light on the wafer which is to be exposed with the light transmitted through the mask pattern, and figure 5(d) shows an intensity distribution of light on the wafer which is to be exposed with the light transmitted through the mask pattern.

In these figures, reference numerals 1a, 1b, and 1c designate light shielding films, reference numeral 3 designates a glass substrate, reference numeral 2 designates a transparent thin film comprising an insulating film such as SiO or SiN for shifting the phase of exposure light (hereinafter referred to as a shifting film), and reference numeral 30 designates a mask pattern comprising the light shielding films 1a, 1b, and 1c, the glass substrate 3, and the shifting films 2. Reference numeral 4 designates an exposure monochromatic light having a single wavelength. Reference numeral 40 designates a wafer which is to be exposed with the light 4 transmitted through the mask pattern 30, and it comprises a substrate 41 and a resist layer 42 disposed on the substrate 41.

In figure 5(a), the phase-shifting film 2 is produced to invert the phase of the exposure light transmitted there-through by 180 degrees and the thickness thereof is represented by:$\text{d = λ/2 (n-1)}$ where, d is the thickness of the phase-shifting film, λ is the wavelength of the exposure light, and n is the refractive index of the phase-shifting film.

When the exposure monochromatic light having a single wavelength 4 is incident from above on the mask pattern 30 on which the phase-shifting film 2 is produced to a required thickness d, because the light at a place in the pattern where light shielding film is absent and the phase-shifting film 2 is present has a difference of 180 degree in phase with relative to the light at a place in the pattern where light shielding film is absent and the phase-shifting film 2 is also absent, the amplitude distribution of light as shown in figure 5(b) appears on the mask pattern 30. The light which has transmitted through the mask pattern 30 reaches the wafer 40, and the light on the wafer 40 presents the amplitude distribution of figure 5(c). In figure 5(c), the dotted line represents the amplitude distribution of the light on the mask pattern 30, and a full line represents amplitude distribution of light on the wafer 40. As shown in this figure, since the amplitude of light on the mask pattern 30 varies due to inversion of the phase at both sides of the light shielding film pattern 1b, there is a place at the light shielding film pattern 1b where the amplitude of light is zero regardless of lights diffracted from the places where light shielding film is absent. In this way, as shown in figure 5(d), there is a place where the light intensity is zero at the light shielding film pattern 1b located between places where light shielding film is absent in the mask pattern, on the substrate to be exposed with light, thereby enabling to produce fine patterns.

The above-described phase-shifting method is effective in a repeating pattern of such as line and space.

On the other hand, in a case of a single pattern such as a space, a supplementary pattern which has an inverted phase is provided around the pattern to obtain fine patterns.

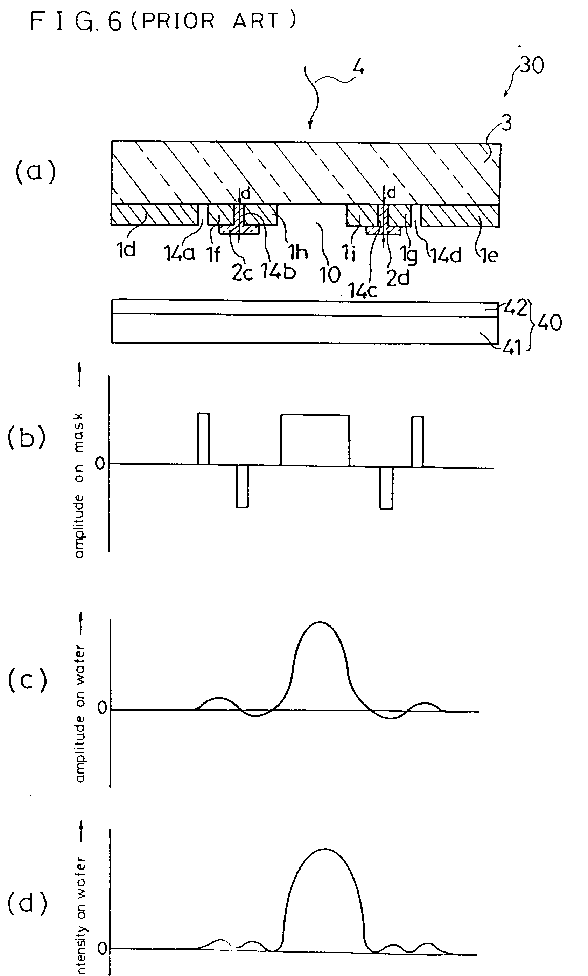

Figures 6(a) to 6(d) show a method of miniaturizing a single pattern using the phase-sifting method, disclosed in Japanese Patent Published Application No.62-67514, in which figure 6(a) is a cross-sectional view of mask pattern, figure 6(b) shows an amplitude distribution of the incident light on the mask pattern, figure 6(c) shows an amplitude distribution of light on a wafer to be exposed with the light transmitted through the mask pattern, and figure 6(d) shows an intensity distribution of light on the wafer.

In figures 6, like elements are given the same numerals as those shown in figures 4 and 5, and reference numerals 1d to 1i designate light shielding films. Reference numerals 2c and 2d designate 180 degree phase-shifting films. Reference numeral 10 designates an aperture. Reference numerals 14a to 14d designate supplementary aperture patterns produced at both sides of the aperture pattern 10, each width of which is too narrow to be imaged by an optical exposure apparatus.

When patterns are transferred onto the resist film 42 provided on the substrate 41 using a mask pattern 30 shown in figure 6(a), the amplitude distribution of light on the mask pattern 30 is as shown in figure 6(b), the phase of light which has transmitted through the aperture patterns 14b and 14c is inverted with respect to that of light which has transmitted through the aperture patterns 14a and 14d. The amplitude and intensity distribution of light on the wafer 40 to be exposed with light are as shown in figures 6(c) and 6(d), respectively, and it is found that only the light which has passed through the aperture pattern 10 is largely transferred.

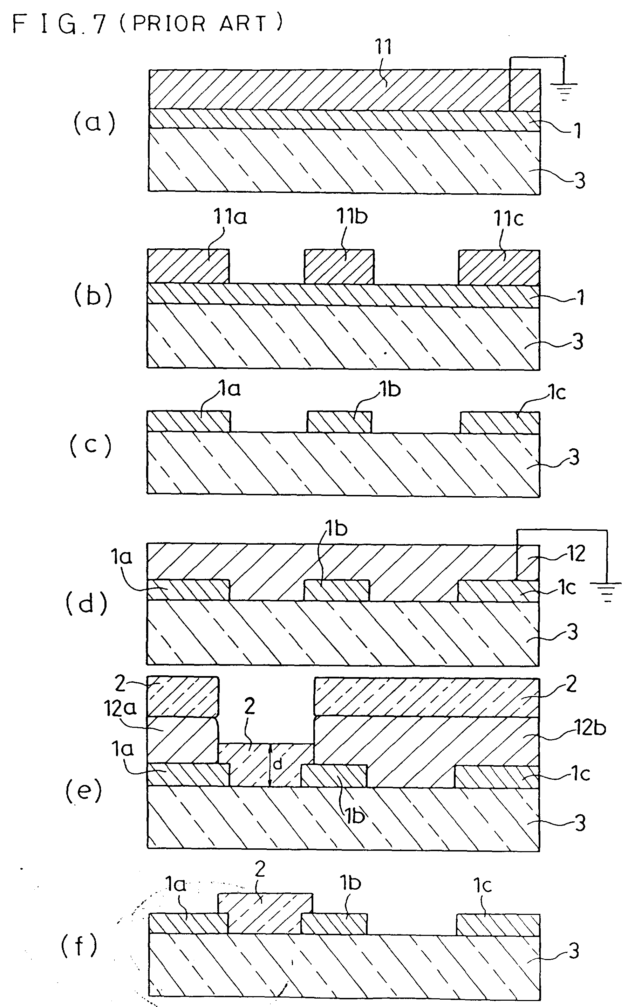

A method of producing a mask pattern of figure 5(a) will be described with reference to figures 7(a) to 7(f).

Firstly, a light shielding film 1 comprising metal such as Cr is produced on the entire surface of glass substrate 3 by deposition or sputtering, and a resist film 11 is plated on the entire surface thereof. Next, the resist 11 is exposed to produce desired patterns using electron beam exposure method. At this time, the light shielding film 1 is grounded to prevent that the glass plate 3 is charged with electric charges due to the light exposure (figure 7(a)).

Thereafter, resist patterns 11a to 11c are produced by a development (figure 7(b)), and the light shielding film 1 is etched using the resist patterns 11a to 11c as a mask to produce light shielding film patterns 1a to 1c, and then the resist patterns 11a to 11c are removed (figure 7(c)).

Thereafter, the entire surface of the partially completed device is plated with resist 12 for producing a phase-shifting film and exposed with the electron beam by electron beam exposure method (figure 7(d)), and thereafter it is developed to produce a resist pattern 12a and 12b. Thereafter, a phase-shifting film 2 comprising a transparent thin film such as SiO or SiN is vapor deposited to a desired thickness (d) using the resist pattern 12a and 12b as a mask (figure 7(e)), and then a phase-shifting film pattern 2 is produced by a lift-off (figure 7(f)).

Here, in the process of electron beam exposure of resist film of figure 7(d), light shielding film pattern 1c is required to be grounded or a metal film is required to be formed on the light shielding film pattern 1c to prevent the substrate 3 from being charged by electric charges.

The mask pattern of figure 6(a) is produced by an electron beam exposure method in the same way as above-described method.

The conventional phase-shifting methods used in the line-and-space repeating pattern and single pattern, both have problems in the method of producing the mask pattern 30.

In the prior art production method, photoresist 11 is plated on the glass substrate 3 which is covered with the light shielding film 1, the surface is subjected to exposure using the electron beam exposure method and developed to produce resist pattern 11a to 11c, light shielding film patterns 1a, 1b, and 1c are produced by etching using the resist pattern 11a to 11c as a mask, and further resist patterns 12a and 12b are produced by using electron beam exposure method and development, and phase-shifting film 2 is produced using a lift-off method. When the electron beam exposure is carried out, grounding is required to prevent the substrate 3 from being charged by an irradiation of electron beam.

However, when the resist 12 is exposed, the light shielding film which is to be grounded is patterned, and light shielding film patterns 1a to 1c are discontinuous on the glass substrate. Therefore, only one pattern such as pattern 1c can be grounded, and a portion between the light shielding films 1a and 1b is not grounded, whereby electrons charge that portion of glass substrate 3.

This charging of the substrate causes problems as explained in the following.

Firstly, in the process of figure 7(d), when the position of resist 12 to be exposed with light is mark-detected with relative to the light shielding film patterns 1a and 1b, the mark-detected position is shifted off due to the influence of electric charge collected at surface of glass substrate 3 at the time of electric beam scanning, which causes a deviation in the position of the phase-shifting film.

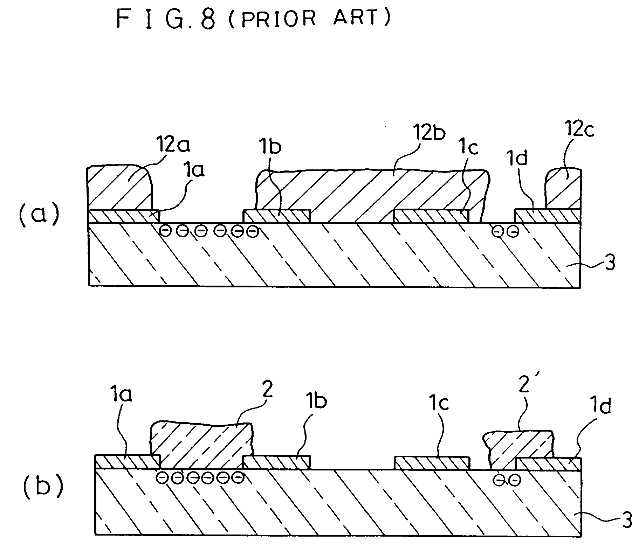

Secondly, as shown in figure 8, in a case where only a pattern ld among light shielding film patterns 1a to 1d is grounded at the time of exposing the resist, the surface of glass substrate 3 is not charged in the vicinity below the light shielding film 1d but is charged at the other portions of the surface of glass plate such as those between the light shielding films 1a and 1b and under the light shielding film 1c (figure 8(a)). When a phase-shifting film is deposited by evaporation in this state, the phase-shifting film 2' produced between the shielding films 1c and 1d becomes of a pattern positionally deviated to the side of the light shielding film 1d unfavorably influenced by electric charges stored at a portion between the shielding films 1a and 1b as shown in figure 8(b).

That is, in the prior art mask pattern production method using the phase-shifting method, the substrate is likely to be charged by using the electron beam exposure method, and it is impossible to obtain a desired phase-shifting film pattern just on the light shielding film at high precision. Therefore, there is a large obstacle when the mask pattern is desired to be fine.

### SUMMARY OF THE INVENTION

The present invention is directed to solving the above described problems and has for its object to provide a method for producing a mask pattern having a phase-shifting film as defined in claim 1.

The method produces the mask pattern at high precision by simple production processes.

Other objects and advantages of the present invention will become apparent from the detailed description given hereinafter; it should be understood, however, that the detailed description and specific embodiment are given by way of illustration only, since various changes and modifications within the scope of the invention as set out in the claims will become apparent to those skilled in the art from this detailed description.

According to the present invention, a method of producing a mask pattern comprises the steps of producing a pattern of light shielding elements having desired width at a front surface of a transparent substrate, producing a positive type photoresist film on the entire surface so as to cover said light shielding elements, exposing the positive type photoresist film on the light shielding film pattern with light from the rear surface of the transparent substrate, removing the exposed areas of photoresist so as to form an over-hanging configuration, depositing a phase-shifting film on the remaining areas of photoresist and the exposed areas of the substrate and removing the remaining photoresist with its overlying areas of phase-shifting film, thereby producing a phase-shifting film pattern at an aperture of the light shielding film pattern separated from the light shielding elements.

The phase-shifting film pattern separated from light shielding film pattern can be produced without requiring electron beam exposure; therefore, a phase-shifting film pattern can be produced self-alignedly at high controllability and high precision by simple production processes.

### BRIEF DESCRIPTION OF THE DRAWINGS

Figures 1(a) to 1(e) are diagrams showing the principle of a function of a mask pattern produced by a method according to the present invention;
Figures 2(a) to 2(e) are diagrams illustrating the method of producing a mask pattern according to the present invention;
Figure 3 is a schematic diagram showing a reduction projecting exposure apparatus.
Figures 4(a) to 4(d) are diagrams for explaining the principle of patterning a mask pattern according to the prior art generally used;
Figures 5(a) to 5(d) are diagrams for explaining the principle of patterning in the phase-shifting method used in the prior art mask pattern;
Figures 6(a) to 6(d) are diagrams for explaining the principle of patterning phase-shifting method used in the prior art mask pattern;
Figures 7(a) to 7(f) are diagrams illustrating a method of producing a mask pattern of figure 5;
Figures 8(a) and 8(b) are diagrams for explaining the problems in the method of producing a mask pattern of figure 7; and

### DETAILED DESCRIPTION OF THE PREFERRED EMBODIMENT

Embodiments of the present invention will be described with reference to the drawings.

First, exposure system by using a reduction projecting exposure apparatus will be explained.

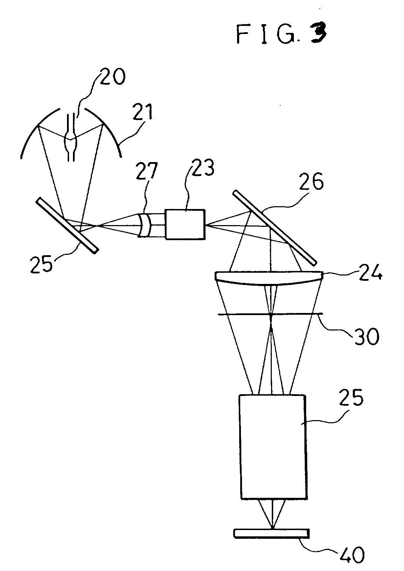

Figure 3 is a schematic diagram showing a reduction projecting exposure apparatus. This system is one that a mask pattern is projected onto the wafer via a reduction lens having high resolution and the wafer is moved by a step and repeat system in X-Y direction so as to expose the entire surface of the wafer. In figure 3, reference numeral 20 designates a Hg lamp. The light emitted from the Hg lamp 20 is reflected on the elliptical mirror 21 and the flat mirror 25, successively. The reflected light on the flat mirror 25 is converted into a parallel light by the lens 27 and thereafter the parallel light enters into the integrator 23. An integrated light reflected by the flat mirror 26 enters a mask pattern 30 via a condenser lens 24. The light transmitted to the mask pattern 30 is projected onto the wafer 40 having a resist mask on the substrate through the reduction lens 25.

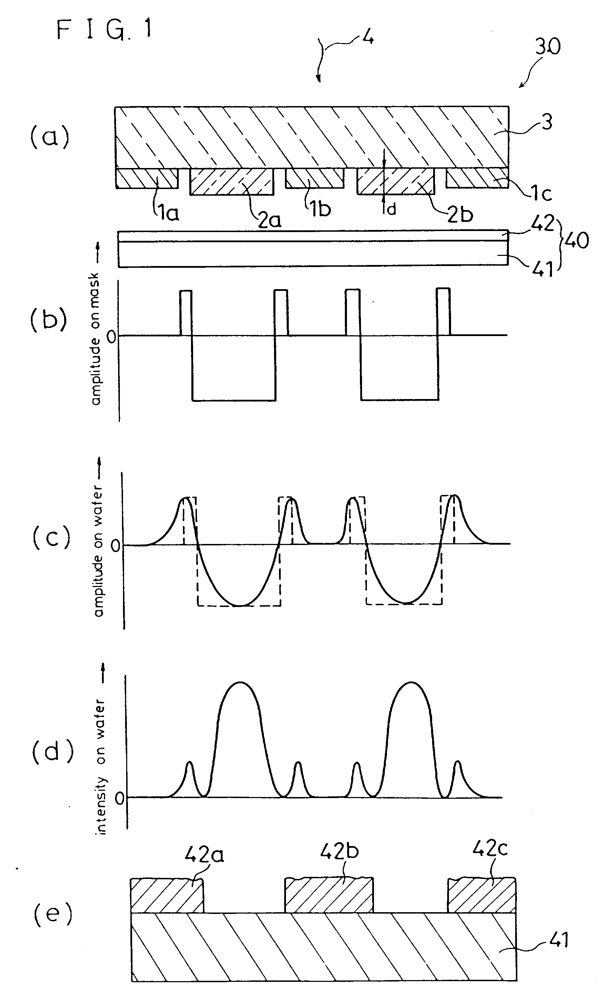

Figure 1 is a diagram showing how the pattern of the mask is projected to the wafer. In figure 1, reference numeral 30 designates a mask pattern comprising a glass substrate 3 and patterns of light shielding films 1a, 1b, and 1c and phase shifting films 2a and 2b disposed on the rear surface of the glass substrate 3. Phase shifting films 2a and 2b disposed on the rear surface of the glass substrate 3 at spaces between the light shielding films la and 1b, and 1b and 1c, respectively. Reference numeral 4 designates an exposure light having a single wavelength incident on the front surface of the glass substrate 3. Reference numeral 40 designates a wafer which is to be exposed with the light 4 transmitted through the mask pattern 30 and it comprises a substrate 41 and a resist layer 42 disposed on the substrate 41 to be exposed.

As shown in figure 1(a), an exposure light 4 having a single wavelength enters a mask pattern from above. The thickness d of phase shifting films 2a and 2b is represented similarly as in the prior art phase-shifting method by the following formula:$\text{d = λ/2 (n-1 )}$ where, d is the thickness of the phase-shifting film, λ is the wavelength of the exposure light, and n is the refractive index of the phase-shifting film.

This thickness is one required to reverse the phase of exposure light which transmitted through the phase-shifting film. The intervals between phase-shifting films 2a, 2b and light shielding film patterns 1a, 1b, 1c are equal to the length which cannot be imaged by using this exposure apparatus such as 0.5 to 1 microns or less in a case where the width of pattern which light shielding film is absent is 5 microns in a mask used in a 1/5 reduction projecting exposure apparatus. Then, the light which transmitted through the phase-shifting films 2a and 2b shows the amplitude distribution of figure 1(b) on the mask pattern. As shown in this figure, the amplitudes of only the lights which transmitted through the phase-shifting films 2a and 2b have phases inverted by 180 degree.

The amplitude distribution of light on the wafer 40 which is exposed with the light which transmitted through the mask pattern 30 is shown in figure 1(c). In this figure, dotted line represents an amplitude of light on the mask pattern 30 and real line represents an amplitude of light on the wafer 40 which is exposed with light. As shown in figure 1(c), the amplitude of the light which transmitted through the phase-shifting film 2a and 2b and the amplitude of the light which transmitted through the pattern having neither a light shielding film 1a to 1c nor a phase-shifting film 2a and 2b are in the relation having a difference in phase by 180 degree; therefore, the amplitude of light at a portion of the wafer of confronting to the both sides of the phase-shifting film 2a and 2b is zero.

As represented by the light intensity distribution on the wafer 40 shown in figure 1(d), the light intensity at a portion of the width corresponding to the width of light which transmitted through the phase-shifting films 2a and 2b can be increased to a value larger than that at a portion of pattern where neither light shielding film nor phase-shifting film is present. Therefore, resolution and contrast of the pattern image which is projected can be enhanced.

Next, the case where a resist pattern having the width of 0.4 microns on the substrate is imaged using a 1/5 reduction projecting exposure apparatus will be described.

In a case where the widths of phase-shifting film patterns 2a and 2b are determined to be 2 microns, and phase shifting films 2a and 2b are produced at spacing of 0.5 microns from the light shielding film patterns 1a to 1c, respectively, the widths of the light shielding film patterns 1a to 1c are determined to be 1 micron. By this, the resist films 42a to 42c which have the pattern width of 0.4 micron can be transferred on the exposed substrate 41 at high precision, as shown in figure 1(e).

When the resist patterns 42a to 42c of p microns are imaged on the substrate using a mask pattern 30 of the present invention and an 1/q reduction projecting exposure apparatus, the pattern width is to be established as follows:
phase-shifting film pattern : (p x q) microns
light shielding film pattern : (p x q) - 2k microns Here, reference character k represents an interval between the phase-shifting film pattern and the light shielding film pattern.

In the above-described embodiment, the width of opening resist patterns 42a to 42c on the substrate 41 are 0.4 microns, but an opening resist patterns 42a to 42c of 0.3 microns can be easily imaged on the substrate 41 by the mask pattern 30.

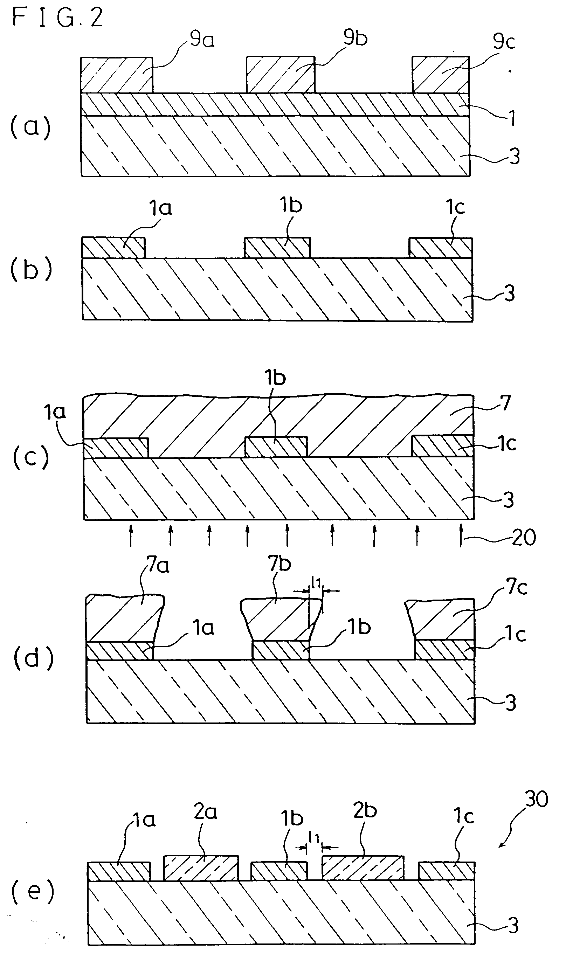

A method of producing the mask pattern 30 of figure 1 is shown in a process flow diagram shown in figures 2(a) to (e). In figure 2, like elements are given the same numerals as those shown in figure 1. Reference numeral 7 designates a positive type resist.

The production method will be described.

Light shielding film 1 comprising metal such as Cr or MoSi is deposited on the entire surface of the glass substrate 3 by evaporation, a resist film is plated thereon, the resist is subjected to exposure radiation to produce a required patterns 9a to 9c using such as electron beam exposure method as shown in figure 2(a), and after development the light shielding films 1 are removed by etching using the resist patterns 9a to 9c as a mask, thereby producing the light-shielding film patterns 1a to 1c as shown in figure 2(b). The light shielding films 1a to 1c are required to be grounded to prevent from charging of the substrate at the electron beam irradiation.

Next, a positive resist 7 is plated on the entire surfaces so as to cover the light shielding film patterns 1a to 1c, and the entire surface is exposed with ultraviolet radiation 20 from the rear surface of the glass substrate 3 as shown in figure 2(c), and to produce overhanging configuration resist patterns 7a to 7c on the light shielding film patterns 1a to 1c as shown in figure 2(d). At this time, the overhanging value ℓ₁ of the resist patterns 7a to 7c shown in figure 2(d) is easily determined depending upon exposure light amount, film thickness of resist 7, and developing condition. That is, the value of ℓ₁ may be determined so as to be equal to the distance between the phase-shifting film pattern and the light shielding film pattern in the mask pattern which are finally produced.

Next, an insulating film such as SiO or SiN which is to become a phase-shifting film is deposited by evaporation on the entire surface. Here, the thickness of the phase-shifting film d is the value represented by formula 1. Thereafter, light shielding films pattern 2a and 2b of the present invention are completed by lift-off as shown in figure 2(e).

In the embodiment of the present invention shown in figure 2, phase-shifting film patterns 2a and 2b are self-alignedly provided with spacing of predetermined distance from the light shielding film patterns 1a to 1c without depositing overlapping on the light shielding film pattern as done in the prior art electron beam exposure method. Therefore, there is no problem about a deviation in the phase-shifting film pattern position due to charging of the substrate by the electron beam exposure while producing the phase-shifting film which has been a problem in the prior art method, and the phase-shifting film pattern can be produced at high controllability and high reproducibility by a simple producing method.

Since the resulting mask pattern comprises a phase-shifting film at an area having a certain distance from the light shielding film pattern, when this mask pattern is used in an optical reduction projecting exposure apparatus using a single wavelength, the resolution and the contrast of pattern image projected on the wafer are enhanced, and the resolution and the depth of focus of photoresist to be patterned are improved. This provides a great effect in producing a fine processed semiconductor device.

## Claims

1. Method of producing a mask pattern for use in an optical exposure apparatus using a single wavelength, the pattern comprising light shielding elements (1) and areas of transparent phase-shifting film (2) separated by gaps from the adjoining light shielding elements, the method comprising the steps of:
generating the pattern of light shielding elements (1) on the front surface of a transparent substrate (3);
applying a positive type photoresist film (7) to the patterned front surface of the substrate;
exposing the photoresist film (7) through the rear surface of the transparent substrate (3);
removing the exposed areas of photoresist, thereby leaving the remaining areas of photoresist overhanging the edges of the light shielding elements (1);
depositing the phase-shifting film (2) over the remaining areas of photoresist and the exposed areas of the substrate; and
removing the remaining photoresist with its overlying areas of phase-shifting film.

2. A method of producing a mask pattern as defined in claim 1 wherein the thickness d of the phase-shifting film is represented by:$\text{d = λ/2(n-1)}$ where d is the thickness of the phase-shifting film, λ is the wavelength of the light with which the mask pattern is to be used, and n is the refractive index of the phase-shifting film.

3. Method of producing a mask pattern as defined in claim 1 or claim 2 wherein the width of said phase-shifting film pattern is (p x q) µm when a pattern of p µm is to be imaged on the wafer by using an 1/q reduction projecting exposure apparatus.

## Patentansprüche

1. Verfahren zum Herstellen eines Maskenmusters zum Verwenden bei einer optischen Belichtungsvorrichtung, die eine einzige Wellenlänge verwendet, wobei das Muster Lichtabschirmelemente (1) und Flächen eines transparenten Phasenverschiebungsfilms (2) aufweist, die durch Spalten von den angrenzenden Lichtabschirmelementen getrennt sind, wobei das Verfahren die Schritte aufweist:
Erzeugen des Musters von Lichtabschirmelementen (1) auf der vorderen Oberfläche eines transparenten Substrats (3);
Auftragen eines Photoresistfilms (7) eines positiven Typs auf die gemusterte vordere Oberfläche des Substrats;
Belichten des Photoresistfilms (7) durch die hintere Oberfläche des transparenten Substrats (3);
Entfernen der belichteten Flächen von Photoresist, wodurch die verbleibenden Flächen von Photoresist, die über die Kanten der Lichtabschirmelemente (1) hängen, zurückbleiben;
Ablagern des Phasenverschiebungsfilms (2) über den verbleibenden Flächen von Photoresist und den belichteten Flächen des Substrats; und
Entfernen des verbleibenden Photoresists mit seinen darüberliegenden Flächen eines Phasenverschiebungsfilms.

2. Verfahren zum Herstellen eines Maskenmusters nach Anspruch 1, bei dem die Dicke des Phasenverschiebungsfilms dargestellt ist durch:$\text{d = λ/2(n-1)}$ wobei d die Dicke des Phasenverschiebungsfilms ist, λ die Wellenlänge des Lichts ist, mit welchem das Maskenmuster zu verwenden ist, und n der Brechungsindex des Phasenverschiebungsfilms ist.

3. Verfahren zum Herstellen eines Maskenmusters nach Anspruch 1 oder Anspruch 2, bei dem die Breite des Phasenverschiebungsfilmmusters (p x q) µm beträgt, wenn ein Muster von p µm mittels Verwendens einer 1/q-Verringerungsprojektions-Belichtungsvorrichtung auf dem Wafer abzubilden ist.

## Revendications

1. Procédé de fabrication d'un motif de masque pour utilisation dans un appareil d'exposition optique utilisant une seule longueur d'onde, le motif comprenant des éléments d'écran de protection contre la lumière (1) et des zones de film de déphasage transparentes (2), séparés par des intervalles des éléments d'écran de protection contre la lumière adjacentes, le procédé comprenant les opérations de :
engendrer le motif d'éléments d'écran de protection contre la lumière (1) sur la face avant ou frontale d'un substrat transparent (3);
appliquer un film de photorésiste de type positif (7) sur la surface frontale en forme de motif du substrat;
exposer le film de photorésiste 7 à travers la surface arrière du substrat transparent (3);
enlever les zones exposées de photorésiste, en laissant les zones restantes de photorésiste à l'état en saillie au-delà des arrêtes des éléments d'écran de protection contre la lumière (1);
déposer le film de déphasage (2) sur les zones restantes de photorésiste et les zones exposées du substrat; et
enlever le photorésiste restant avec ces zones en saillie de film de déphasage.

2. Procédé de production d'un motif de masque tel que défini dans la revendication 1, selon lequel l'épaisseur d du film de déphasage est représenté par :$\text{d = λ/2(n-1)}$ où d est l'épaisseur du film de déphasage, λ est la longueur d'onde de la lumière avec lequel le motif de masque doit être utilisé, et n est l'indice de réfraction du film de déphasage.

3. Procédé de fabrication d'un motif de masque tel que défini dans la revendication 1 ou 2, selon lequel la largeur du motif de film de déphasage precité est (p x q) µm lorsqu'un motif de p µm doit être représenté par une image sur la pastille en utilisant un photorépétiteur à réduction de 1/q.
